**Europäisches Patentamt**

**European Patent Office**

**Office européen des brevets**

(19)

(11)   **EP 1 258 085 B1**

(12)   **EUROPÄISCHE PATENTSCHRIFT**

(45) Veröffentlichungstag und Bekanntmachung des Hinweises auf die Patenterteilung:
**01.09.2004   Patentblatt 2004/36**

(51) Int Cl.⁷: **H03M 13/29**, H03M 13/37

(21) Anmeldenummer: **01913506.0**

(22) Anmeldetag: **12.01.2001**

(86) Internationale Anmeldenummer:
**PCT/DE2001/000110**

(87) Internationale Veröffentlichungsnummer:
**WO 2001/063773 (30.08.2001 Gazette 2001/35)**

(54) **VERFAHREN ZUM ANPASSEN DER EINEM TURBO-CODIERER ZUZUFÜHRENDEN DATENBLÖCKE UND ENTSPRECHENDE KOMMUNIKATIONSVORRICHTUNG**

METHOD FOR ADAPTING THE DATA BLOCKS TO BE SUPPLIED TO A TURBO CODER AND A CORRESPONDING COMMUNICATIONS DEVICE

PROCEDE POUR ADAPTER LES BLOCS DE DONNEES A CONDUIRE JUSQU'A UN CODEUR TURBO, ET DISPOSITIF DE COMMUNICATION CORRESPONDANT

(84) Benannte Vertragsstaaten:
**DE FR GB IT**

(30) Priorität: **22.02.2000   DE 10008064**

(43) Veröffentlichungstag der Anmeldung:
**20.11.2002   Patentblatt 2002/47**

(73) Patentinhaber: **SIEMENS AKTIENGESELLSCHAFT
80333 München (DE)**

(72) Erfinder:
• **WIEDMANN, Ralf
81369 München (DE)**
• **RAAF, Bernhard
81475 München (DE)**
• **LOBINGER, Andreas
83714 Miesbach (DE)**

(56) Entgegenhaltungen:
**WO-A-00/64057        WO-A-01/05059
US-A- 5 889 791**

Bemerkungen:
Die Akte enthält technische Angaben, die nach dem Eingang der Anmeldung eingereicht wurden und die nicht in dieser Patentschrift enthalten sind.

**Beschreibung**

Verfahren zum Anpassen der einem Turbo-Codierer zuzuführenden Datenblöcke und entsprechende Kommunikationsvorrichtung

Die vorliegende Erfindung betrifft ein Verfahren zum Anpassen der einem Turbo-Codierer zuzuführenden Datenblöcke sowie eine entsprechende Kommunikationsvorrichtung.

In Kommunikationssystemen werden sogenannte Kanalcodierer zur Codierung der an einen entsprechenden Empfänger zu sendenden Datenbits eingesetzt. Durch die Kanalcodierung werden den eigentlichen Datenbits redundante Bits hinzugefügt, die im Empfänger eine zuverlässigere Detektion der Datenbits ermöglichen.

Aus US-A-5889791 ist ein Verfahren zur Codierung bekannt, bei dem einem Datenblock vor der Codierung zusätzliche Bits mit einem bekannten vordefinierten Wert hinzugefügt werden, wobei die zusätzlichen Bits dem Datenblock vorangestellt werden. Dieses Voranstellen von vorbekannten Bits erfolgt dabei vor der Codierung mit einem zyklischen Code (Reed Solomon).

Aus "MA, HOWARD H.; WOLF JACK K.: 'On Tail-Biting Convolutional Codes', IEEE TRANSACTIONS ON COMMUNICATIONS, XP-2038443, Februar 1986, Band 34, Nr. 2, Seiten 104-110" ist ein Segmentierungsverfahren für einen Blockcoder bekannt.

Hinsichtlich der Kanalcodierung ist u.a. die Verwendung von sogenannten Turbo-Codes bekannt, die beispielsweise auch für den augenblicklich in der Standardisierung befindlichen UMTS-Mobilfunkstandard ('Universal Mobile Telecommunication System') vorgesehen sind.

Ein Turbo-Codierer stellt eine Parallelschaltung aus zwei Faltungscodierern dar, wobei einem der beiden Faltungscodierer ein Interleaver vorgeschaltet ist, welcher die zu codierenden Datenbits zeitlich umordnet. Die Datenbits werden dem Turbo-Codierer blockweise zugeführt. Da der interne Interleaver des Turbo-Codierers nur ab einer gewissen Blockgröße definiert ist, muß jeder dem Turbo-Codierer zugeführte Datenblock eine entsprechende minimale Größe M, d.h. eine entsprechende minimale Anzahl von M Datenbits, aufweisen. Gemäß dem UMTS-Standard wurde diese minimale Blockgröße beispielsweise auf M = 40 Bits festgelegt.

Besitzen die dem Turbo-Codierer zugeführten Datenblöcke eine Blockgröße, welche kleiner als die minimale Blockgröße M des Turbo-Codierers ist, muß die Länge der Datenblöcke entsprechend angepaßt werden, ehe die Datenblöcke dem Turbo-Codierer zugeführt werden.

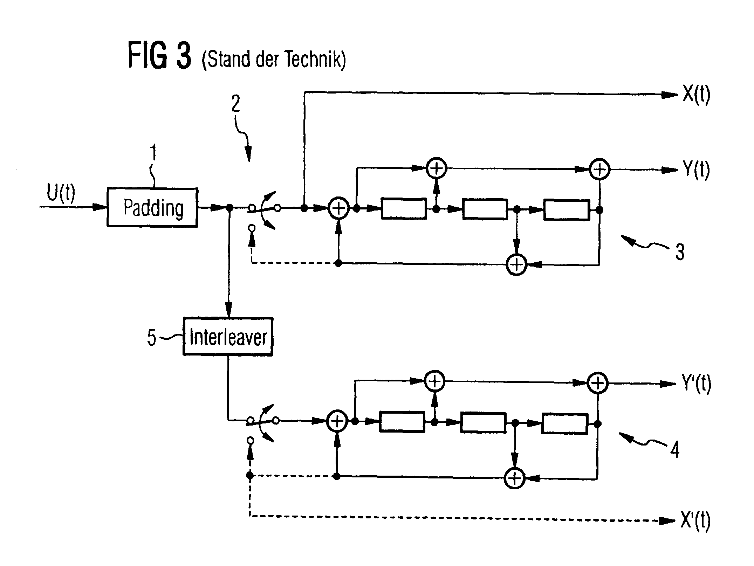

In Fig. 3 ist ein Turbo-Codierer gemäß dem Stand der Technik dargestellt, wie er beispielsweise in einem UMTS-Mobilfunksender zum Einsatz kommen kann.

Der dargestellte Turbo-Codierer 2 umfaßt einen ersten Faltungscodierer 3 sowie einen zweiten Faltungscodierer 4, wobei die Datenbits des jeweils zu codierenden Datenblocks dem zweiten Faltungscodierer 4 über einen Interleaver 5 zugeführt und dadurch zeitlich umgeordnet werden. Die beiden Faltungscodierer 3 und 4 sind durch rekursive Registerschaltungen gebildet. Am Eingang des Turbo-Codierers 2 werden die zu codierenden Bits uncodiert abgegriffen und als sogenannte systematischen Bits X(t) ausgegeben. Von dem ersten Faltungscodierer 3 werden den codierten Datenbits entsprechende erste Paritätsbits Y(t) ausgegeben, während von dem zweiten Faltungscodierer 4 zweite Paritätsbits Y'(t) ausgegeben werden. Durch entsprechende Umschaltung zwischen den einzelnen Signalzweigen X(t), Y(t) und Y'(t) wird am Ausgang des Turbo-Codierers 2 die Bitsequenz X(0), Y(0), Y'(0), X(1), Y(1), Y'(1) etc. als Ausgangsbitstrom ausgegeben.

Nachdem sämtliche Daten- oder Informationsbits codiert worden sind, wird zunächst der in Fig. 3 gezeigte Eingangsschalter, welcher dem oberen Faltungscodierer 3 zugeordnet ist, umgeschaltet, so daß der entsprechende in Fig. 3 gestrichelt angedeutete Rückkopplungspfad aktiviert wird. Gleichzeitig wird der untere Faltungscodierer 4 deaktiviert. Die auf diese Weise nächsten drei gewonnenen Werte für X(t) und Y(t) werden der Ausgabesequenz hinzugefügt und dienen der sogenannten Terminierung des oberen Faltungscodierers 3, wodurch der Faltungscodierer 3 wieder in einen definierten Ausgangszustand gebracht wird. Anschließend wird der in Fig. 3 gezeigte Eingangsschalter, welcher dem unteren Faltungscodierer 4 zugeordnet ist, umgeschaltet, so daß der entsprechende in Fig. 3 gestrichelt angedeutete Rückkopplungspfad aktiviert wird. Gleichzeitig wird der obere Faltungscodierer 3 deaktiviert. Die auf diese Weise nächsten drei gewonnenen Werte für X'(t) und Y'(t) werden ebenfalls der Ausgabesequenz hinzugefügt und dienen der Terminierung des unteren Faltungscodierers 4.

Um die dem Turbo-Codierer 2 zugeführten Datenblöcke an die minimal erforderliche Blocklänge M des Turbo-Codierers 2 anzupassen, können die Datenbits U(t) jedes Datenblocks am Ende mit vordefinierten Bits ('Dummy-Bits'), welche beispielsweise insbesondere den Wert '0' besitzen, aufgefüllt werden. Das auch als 'Padding' bezeichnete Einfügen der Dummy-Bits in die Datenblöcke wird gemäß Fig. 3 von einer dem Turbo-Codierer 2 vorgeschalteten Padding-Einrichtung 1 wahrgenommen.

Das Auffüllen der einzelnen Datenblöcke am Ende mit Dummy-Bits ist jedoch insofern nachteilig, als daß hierdurch bei Rücksetzung bzw. Terminierung ('Termination') des Turbo-Codierers 2 nicht-konstante Datenbits erzeugt werden, die entweder nicht ausgenutzt werden können oder die Komplexität des Empfängers erhöhen.

Der vorliegenden Erfindung liegt daher die Aufgabe zugrunde, ein Verfahren zum Anpassen der einem Turbo-Codierer zuzuführenden Datenblöcke sowie eine entsprechende Kommunikationsvorrichtung vorzuschlagen, wobei eine Anpassung der Blocklänge der Datenblöcke an die minimal erforderliche Blocklänge des Turbo-Codierers ohne den zuvor beschriebenen Nachteil der suboptimalen Terminierung des Turbo-Codierers gewährleistet ist.

Diese Aufgabe wird erfindungsgemäß durch die Merkmale der unabhängigen Ansprüche gelöst. Die Unteransprüche definieren vorteilhafte und bevorzugte Ausführungsformen der vorliegenden Erfindung.

Erfindungsgemäß wird vorgeschlagen, die minimal erforderliche Datenblocklänge des Turbo-Codierers dadurch zu erhalten, daß eine entsprechende Anzahl von Bits mit einem bekannten vordefinierten Wert ('Dummy-Bits') dem jeweils zu codierenden Datenblock vorangestellt werden. Diese Vorgehensweise ist äußerst einfach zu implementieren und hat keine wesentliche Erhöhung der Komplexität zur Folge. Zudem ist auf diese Weise sichergestellt, daß die Rücksetzung (Terminierung) des Turbo-Codierers über die vorgesehenen 'Tail'-Bits hinaus keine weiteren nicht-konstanten Bits erzeugt werden. Des weiteren können die hinzugefügten redundanten Dummy-Bits in einfacher Weise später für eine Verbesserung der Übertragungsqualität genutzt werden.

Für die weitere Verarbeitung des von dem Turbo-Codierer ausgegebenen Bitstroms kann es vorteilhaft sein, wenn die hinzugefügten Dummy-Bits zumindest teilweise wieder nach der Turbo-Codierung entfernt werden.

Zu diesem Zweck können die zu entfernenden Dummy-Bits markiert und anschließend bei der Datenübertragung weggelassen werden, wobei es unter Berücksichtigung der vor der nachfolgenden Ratenanpassung durchzuführenden Separation des von dem Turbo-Codierer ausgegebenen Bitstroms vorteilhaft ist, wenn die Dummy-Bits stets in Gruppen von drei Bits entfernt werden.

Des weiteren können die Positionen der Dummy-Bits auch durch Repetieren einzelner Information tragender Bits (Datenbits) der jeweiligen Bitsequenz ersetzt werden, wobei das Repetieren sowohl zyklisch als auch blockweise erfolgen kann.

Das Problem der Anpassung der Datenblocklänge an die für den Turbo-Codierer minimal erforderliche Datenblocklänge kann alternativ auch dadurch realisiert werden, daß der jeweils zu codierende Datenblock durch Repetieren seiner Datenbits auf die minimal erforderliche Blocklänge des Turbo-Codierers gebracht wird, wobei die Repetierung der einzelnen Bits sowohl zyklisch als auch blockweise erfolgen kann.

Die Erfindung kann vorzugsweise in UMTS-Mobilfunkvorrichtungen eingesetzt werden, ohne jedoch auf diesen Anwendungsbereich beschränkt zu sein.

Die vorliegende Erfindung wird nachfolgend näher anhand bevorzugter Ausführungsbeispiele unter Bezugnahme auf die beigefügte Zeichnung näher erläutert.

Fig. 1 zeigt ein Blockschaltbild einer Kommunikationsvorrichtung mit einem Turbo-Codierer gemäß einem ersten Ausführungsbeispiel der vorliegenden Erfindung,

Fig. 2 zeigt ein Blockschaltbild einer Kommunikationsvorrichtung mit einem Turbo-Codierer gemäß einem zweiten Ausführungsbeispiel der vorliegenden Erfindung, und

Fig. 3 zeigt ein Blockschaltbild einer bekannten Kommunikationsvorrichtung mit einem Turbo-Codierer gemäß dem Stand der Technik.

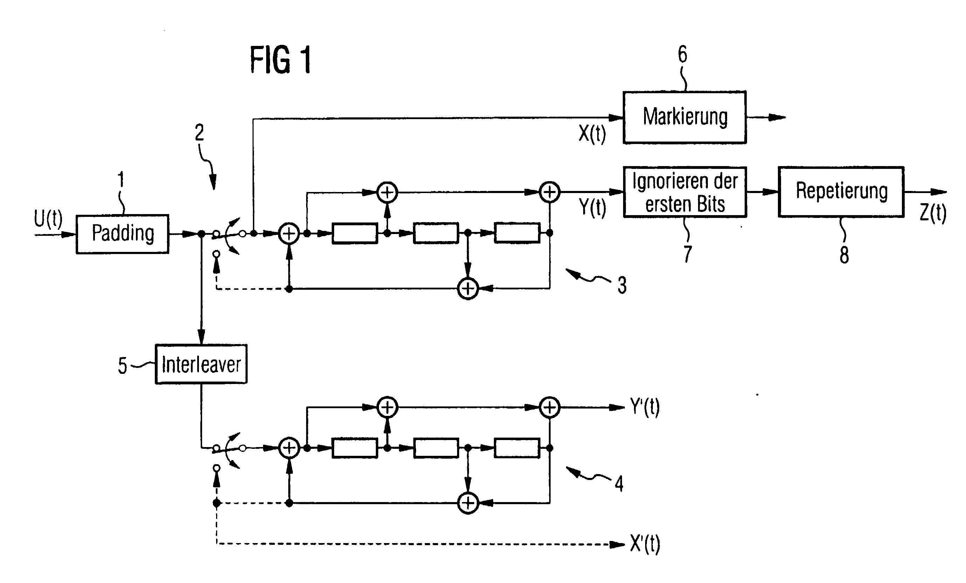

In Fig. 1 ist ein Turbo-Codierer 1 dargestellt, wie er in einer erfindungsgemäßen Kommunikationsvorrichtung, beispielsweise einem UMTS-Mobiltelefon, eingesetzt werden kann. Der Aufbau und die Funktionsweise des Turbo-Codierers 2 entspricht dem bereits anhand Fig. 3 erläuterten Turbo-Codierer, so daß an dieser Stelle nicht wiederholt darauf eingegangen wird. Vielmehr werden nachfolgend lediglich die Unterschiede zwischen den in Fig. 1 gezeigten Komponenten und dem in Fig. 3 gezeigten Turbo-Codierer erläutert.

Dem Turbo-Codierer 2 ist analog zu Fig. 3 eine Padding-Einrichtung 1 vorgeschaltet, welche die einzelnen zu codierenden Datenblöcke mit Dummy-Bits auffüllt, um somit die Blocklänge der Datenblöcke an die dem jeweiligen Turbo-Codierer 2 entsprechende minimal erforderliche Blocklänge M anzupassen. Im Gegensatz zu dem Stand der Technik ist die Padding-Einrichtung 1 jedoch derart ausgestaltet, daß jedem zu codierenden Datenblock eine entsprechende Anzahl von Dummy-Bits nicht nachgestellt, sondern vorangestellt wird. Dem Turbo-Codierer 2 werden somit zuerst die hinzugefügten Dummy-Bits zugeführt. Daraus ergibt sich der Vorteil, daß die bereits anhand Fig. 3 erläuterte Rücksetzung des Turbo-Codierers 2 nicht beeinträchtigt wird. Zudem können bei dieser Vorgehensweise gegenüber dem Stand der Technik mehr erste Paritätsbits Y (t) als redundant markiert werden, was - wie nachfolgend noch näher erläutert wird - bei der weiteren Verarbeitung des codierten Bitstroms vorteilhaft sein kann.

Soll ein Datenblock der Länge N<M mit den Datenbits U(0), U(1), U(2)...U(N-1) codiert werden, kann die Funktionsweise der Padding-Einrichtung 1 durch folgende Beziehungen beschrieben werden, wobei X(0), X(1), X(2)...X(i) den Ausgangsbits der Padding-Einrichtung 1 bzw. den Eingangsbits des Turbo-Codierers 2 (d.h. den systematischen Bits) entsprechen und davon ausgegangen wird, daß zum Auffüllen des Datenblocks Dummy-Bits mit dem vordefinierten Wert '0' verwendet werden:

$$X(i) = 0 \qquad \text{für } 0 \leq i < M\text{-}N$$

$$X(i) = U(i\text{-}M\text{+}N) \qquad \text{für } M\text{-}N \leq i \leq M\text{-}1$$

Dies kann auch beschrieben werden als:

```
for i = 0 to M-N-1
        X(i) = 0
end for
for i = M-N to M-1
        X(i) = U(i-M+N)
end for
```

oder mit P = M-N als die Anzahl der eingefügten Dummy-Bits mit dem vordefinierten Wert '0' als:

```
for i = 0 to P-1
        X(i) = 0
end for
for i = P to M-1
        X(i) = U(i-P)
end for
```

oder mit:

i = k-1 (Indizierung beginnt mit 0 statt mit 1)

$P = Y_i$

$M = K_i$

$X = o_{i1}$

$U = x_i$

als:

```
for k = 1 to Y_i
```

$$o_{i_1 k} = 0$$

```
end for
for k = Y_i+1 to K_i
```

$$o_{i_1 k} = x_{i,(k-Y_i)}$$

```
end for
```

Die zuvor beschriebene Vorgehensweise hat zur Folge, daß sowohl bei den systematischen Bits X(t) als auch bei den ersten Paritätsbits Y(t) die ersten M-N Bits den konstanten Wert '0' aufweisen (bei UMTS gilt M = 40). Würde das Padding hingegen am Ende eines Datenblocks durchgeführt werden, so würden im allgemeinen die letzten M-N Bits der ersten Paritätsbits Y(t) nicht den Wert '0' besitzen und müssen als Datenbits betrachtet werden, so daß sie nach der Turbo-Codierung nicht ersetzt oder entfernt werden können.

Das Wissen um diese Bits mit dem konstanten Wert '0' kann beispielsweise in dem Empfänger der codierten Datenbits zur Verbesserung des Empfangs verwendet werden. Auf dem Gebiet der Mobilfunktechnik eingesetzte Decoder verwenden zur Decodierung der empfangenen Datenbits typischerweise sogenannte 'Soft Decision'-Algorithmen, d.h. es wird nicht nur der Schätzwert des jeweils empfangenen Bits verwendet, sondern zusätzlich auch eine dem jeweiligen Bit zugewiesene Signifikanz, welche eine Wahrscheinlichkeit dafür angibt, daß das Bit tatsächlich den detektierten Wert besitzt. Bei Verwendung von a priori bekannten Bits, wie beispielsweise den erfindungsgemäß hinzugefügten Dummy-Bits, kann zur Verbesserung des Empfangs das empfangene Signal eines a priori bekannten Bits ignoriert und für die weitere Verarbeitung durch den Wert eines absolut sicher empfangenen Bits ersetzt werden.

Wird das Padding wie oben angegeben am Anfang der einzelnen Datenblöcke durchgeführt (sogenanntes 'Front Padding'), kann die Implementierung solcher optimierter Empfangsalgorithmen gegenüber dem Fall eines am Ende der Datenblöcke durchgeführten Padding erleichtert werden.

Die durch das zuvor beschriebene Padding eingefügten Dummy-Bits werden vorzugsweise nach der Turbo-Codierung wieder aus dem Ausgangsdatenstrom des Turbo-Codierers 2 entfernt. Die Dummy-Bits können am einfachsten aus den systematischen Bits X(t) (welche den Eingangsbits des Turbo-Codierers 2 entsprechen) und/oder den ersten Paritätsbits Y(t) entfernt werden, da sich bei diesen Bitfolgen die bekannten Dummy-Bits jeweils in einem Datenblock am Anfang befinden. Die zweiten Paritätsbits Y'(t) werden hingegen aus der Eingangsbitfolge X(t) nach Verwürfelung durch den Interleaver 5 berechnet, so daß die zweiten Paritätsbits Y'(t) die bekannten Dummy-Bits und unbekannte Informationsbits ungeordnet enthalten, was die Identifizierung der bekannten Dummy-Bits erschwert.

Je nachdem, welche Bits nach der Turbo-Codierung wieder entfernt werden, können die folgenden Fälle unterschieden werden.

Da die uncodierten systematischen Bits X(t) des Turbo-Codierers 2 - wie bereits erwähnt worden ist - die beim Padding vorangestellten Dummy-Bits unverändert aufweisen, empfiehlt es sich, die keine Informationen aufweisenden Dummy-Bits zu markieren und dann in einer späteren Verarbeitung zu entfernen. Aus diesem Grund ist bei dem in Fig. 1 gezeigten Ausführungsbeispiel eine Markierungseinrichtung 6 in dem Signalpfad der systematischen Bits X(t) vorgesehen, welche die Bits X(i) für $0 \leq i < M\text{-}N$ markiert, so daß die markierten Bits bei der nachfolgenden Datenübertragung ausgelassen werden.

Die ersten Paritätsbits Y(t) des Turbo-Codierers 2 besitzen entsprechend den beim Padding eingefügten Dummy-Bits zu Anfang den Wert '0'. Auch die Bits Y(i) für $0 \leq i < M\text{-}N$ können daher analog zu der für die systematischen Bits X(t) zuvor beschriebenen Vorgehensweise markiert werden, um anschließend bei der Übertragung weggelassen zu werden.

Nach der Turbo-Codierung wird in der Regel eine Anpassung der Datenrate ('Rate Matching') des von dem Turbo-Codierer 2 ausgegebenen Bitstroms durchgeführt. Dabei wird der Bitstom, welcher die systematischen Bits X(z), die ersten Paritätsbits Y(t) und die zweiten Paritätsbits Y'(t) umfaßt, wieder in die einzelnen Bitsequenzen X(t), Y(t) und Y'(t) aufgeteilt, wobei dieser Aufteilungsschritt auch als Separation bezeichnet wird. Anschließend wird in der Regel nur die Datenrate der Paritätsbits Y(t) und Y'(t) durch Weglassen (Punktieren) einzelner Bits an die für die Datenübertragung erforderlich Datenrate angepaßt. Ebenso ist eine Anpassung der Datenrate durch Wiederholen (Repetieren) einzelner Bits möglich, wobei im Falle des Repetierens alle drei Bitklassen X(t), Y(t) und Y'(t) repetiert werden.

Für die Separation ist erforderlich, daß die Anzahl der von dem Turbo-Codierer ausgegebenen Bits durch den Wert 3 teilbar ist. Um die Separation ohne Änderungen durchführen zu können, empfiehlt es sich daher, nicht grundsätzlich alle bekannten Dummy-Bits zu markieren und bei der Übertragung wegzulassen, sondern nur jeweils Dummy-Bit-Gruppen, die drei Dummy-Bits umfassen. Werden beim Padding beispielsweise acht Dummy-Bits hinzugefügt, so würden bei dieser Vorgehensweise nur jeweils sechs Bits weggelassen werden. Dabei kann entweder von jeder Klasse von Bits eine durch den Wert 3 teilbare Anzahl von Bits oder insgesamt eine durch den Wert 3 teilbare Anzahl von Bits, beispielsweise sieben Paritätsbits Y(t) und acht systematische Bits X(t), weggelassen werden.

In einem UMTS-Sender würden dann bei dieser Vorgehensweise die drei separierten Bitströme nach der Separation nicht ausschließlich Bits einer Klasse enthalten, sondern jeder Bitstrom würde am Anfang eines Blocks auch zweite Paritätsbits aufweisen. Dies hat zur Folge, daß die zweiten Paritätsbits Y'(t) insgesamt während der Ratenanpassung nicht vollständig gleichmäßig punktiert werden. Bei UMTS ist jedoch derzeit für die Ratenanpassung ein Punktierungsalgorithmus definiert, der eine alternierende Punktierung der ersten und zweiten Paritätsbits Y(t) und Y'(t) vorsieht. Dieser Punktierungsalgorithmus bewirkt, daß die Punktierung der zweiten Paritätsbits, die am Anfang jedes Blocks liegen, trotzdem relativ gleichmäßig punktiert werden, so daß die zuvor bezüglich des Markierens und Weglassens der bekannten Dummy-Bits beschriebene Vorgehensweise in UMTS-Kommunikationssystemen für die nachfolgende Ratenanpassung unschädlich ist. Des weiteren werden diejenigen zweiten Paritätsbits Y'(t), die bei der Separation den systematischen Bits X(t) vorangestellt werden, nicht punktiert, wodurch die effektive Punktierungsrate der zweiten Paritätsbits Y'(t) am Anfang geringer ist und daher nicht die Leistungsfähigkeit ('Performance') der Erfindung beeinträchtigt.

Wie bereits erwähnt worden ist, muß darauf geachtet werden, daß die Anzahl der Bits der von dem Turbo-Codierer 2 ausgegebenen Bitsequenzen X(t), Y(t), Y'(t) für die in der entsprechenden Kommunikationsvorrichtung, beispielsweise einem Mobiltelefon, nachgeschalteten Algorithmen geeignet sind. Insbesondere kann für die zuvor beschriebene Separation des aus den einzelnen Bitsequenzen X(t), Y(t) und Y'(t) zusammengesetzten Bitstroms zum Zweck der Ratenanpassung erforderlich sein, daß die Anzahl der Ausgangsbits pro Bitsequenz X(t), Y(t) und Y'(t) gleich groß sein muß (ohne Berücksichtigung der bei der Terminierung des Turbo-Codierers 2 hinzugefügten Tail Bits). Diese Voraussetzung würde durch ein ungleichmäßiges Entfernen (Punktieren) oder Weglassen von bekannten Dummy-Bits in den einzelnen Bitsequenzen gestört werden. Falls dies unerwünscht ist, bietet es sich an, die Dummy-Bits nicht einfach wegzulassen, sondern ihre Positionen durch andere, insbesondere Information tragende Bits zu belegen, die somit mehrmals übertragen werden. Zu diesem Zweck ist in Fig. 1 hinsichtlich des Y(t)-Signalpfads eine Einrichtung 7 vorgesehen, welche die in der ersten Paritätsbitsequenz Y(t) enthaltenen bekannten Dummy-Bits ignoriert, sowie eine Einrichtung 8, welche die dadurch frei werdenden Positionen in der ersten Paritätsbitsequenz Y(t) durch bestimmte Information tragende Bits belegt, d.h. diese Information tragenden Bits werden repetiert.

Zur Realisierung dieses Ansatzes müssen bei dem in Fig. 1 gezeigten Ausführungsbeispiel die Information tragenden Bits der ersten Paritätsbitsequenz Y(t), d.h. die Bits Y(i) für $M-N \leq i \leq M-1+T$, in einem Speicher geschrieben werden, wobei M die minimal erforderliche Bitlänge eines Datenblocks, N die Datenblocklänge vor dem Padding und T die Anzahl der für die Terminierung des Turbo-Codierers 2 erforderlichen Tail Bits bezeichnet. Bei UMTS-Kommunikationssystemen beträgt M = 40 und T = 6. Anschließend können die in den Speicher geschriebenen Information tragenden Bits zyklisch ausgelesen werden, bis die gewünschten Positionen der beim Padding hinzugefügten Dummy-Bits besetzt worden sind. Für die Bits der von der Repetierungseinrichtung 8 ausgegebenen Bitsequenz Z(t) ergeben sich somit folgende Werte: $Z(i) = S(i \bmod (N+T))$ für $0 \leq i \leq M-1+T$, wobei S(i) die nacheinander in den Speicher geschriebenen Information tragenden Bits bezeichnet. Bei dieser Vorgehensweise werden somit die Information tragenden Bits als Ersatz für die entsprechenden Dummy-Bits in der Reihenfolge S(0), S(1), S(2),..., S(N+T-1), S(0), S(1), ... ausgegeben.

Ebenso ist ein Repetieren gemäß der Beziehung $Z(i) = S((i+N-M) \bmod (N+T))$ für $0 \leq i \leq M-1+T$ möglich (die mod-Funktion erzeugt auf jeden Fall einen positiven Wert, z.B. -9 mod 10 = 1) Der Vorteil bei dieser Vorgehensweise besteht darin, daß für den Empfänger zwei Alternativen zur Realisierung offenstehen. Gemäß der ersten Alternative kann der Empfänger die repetierten Bits am Anfang ignorieren und nur die Bits des letzten Bitblocks Z(i) mit $42-N-T-1 \leq i \leq 42-1$ auswerten. Gemäß der zweiten Alternative können sämtliche Bits, d. h. auch die repetierten Bits, ausgewertet werden.

Bei obigen Formel sind die Werte der "hinteren" Bits Z(i) mit $42-N-T-1 \leq i \leq 42-1$ identisch zu demjenigen Fall, bei dem keine Repetierung, sondern nur das erfindungsgemäße Front-Padding angewendet wird. Dies besitzt den Vorteil, daß ein Empfänger, der für das Front-Padding ausgelegt ist und die Dummy-Bits vor der Decodierung mit dem Soft-Decision-Informationswert "sicher '0'" belegt, auch ein Signal verarbeiten kann, bei dem die oben genannte Repetierung durchgeführt worden ist. Es ergibt sich dann zwar keine Verbesserung der Performance, da die Repetierung nicht ausgenutzt wird, die Repetierung kann aber in den entsprechenden Mobilfunkstandard erst in einer späteren Stufe eingeführt werden, ohne daß dadurch Kompatibilitätsprobleme mit älteren Empfängern entstehen. Dazu muß jedoch für den Empfänger festgelegt sein, daß er die bekannten Dummy-Bits ignoriert bzw. nicht auswertet oder diese ersetzt, wobei dies insbesondere die systematischen Bits X(t) und die ersten Paritätsbits Y(t) betrifft.

Anstelle eines zyklischen Auslesens bzw. Repetierens der Information tragenden Bits können die in dem Speicher befindlichen Bits auch blockweise repetiert werden. Durch das blockweise Repetieren wird zwar geringfügig die Komplexität erhöht, die BitfehlerHäufigkeit wird hingegen bei anschließender Anwendung eines Algorithmus zur Ratenanpassung oder eines Interleavers verringert.

Für das blockweise Repetieren kann beispielsweise folgender Algorithmus verwendet werden:

$$Z(i) = S\left( \frac{i \cdot (N + T)}{M + T} \right)$$

für $0 \le i \le M\text{-}1 + T$, d.h. die in dem Speicher befindlichen Information tragenden Bits werden als Ersatz für die Dummy-Bits in der Reihenfolge S(0), S(0), ..., S(0), S(1), S(1), ..., S(1), S(2), S(2), ... ausgegeben so daß jeweils ein Information tragendes Bit mehrfach repetiert wird.

Alternativ könnten auch die ersten Information tragenden Bits

$$\left( \frac{M + T}{N + T} \right) - \mathtt{mal}$$

wiederholt werden, während die nachfolgenden Bits einmal weniger wiederholt werden. Diese Vorgehensweise ist etwas einfacher als die zuvor beschriebene Alternative, wobei die erste Alternative allerdings die häufiger gesendeten Bits gleichmäßiger über alle Bits verteilt.

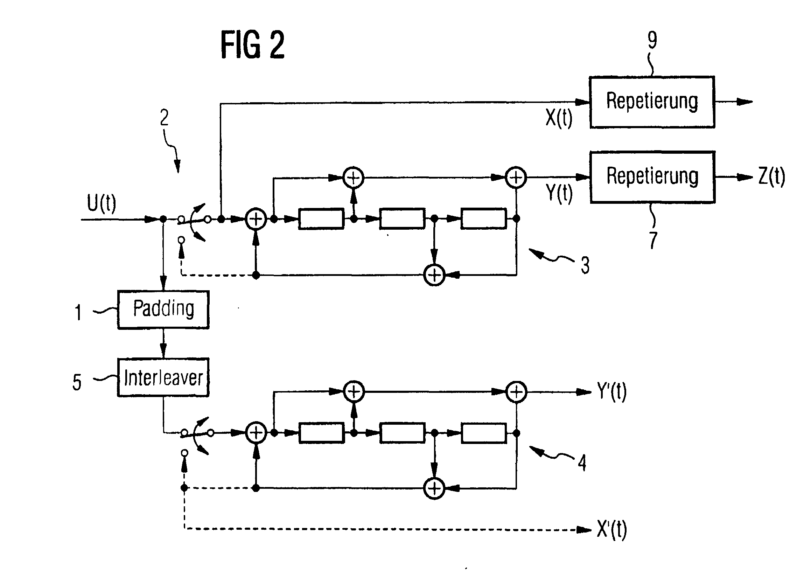

In Fig. 2 ist ein weiteres Ausführungsbeispiel für einen erfindungsgemäßen Turbo-Codierer dargestellt.

Bei diesem Ausführungsbeispiel wird das Ignorieren von Dummy-Bits umgangen. Es werden durch entsprechende Repetierungseinrichtungen 8 und 9 sowohl die ersten Paritätsbits Y(t) als auch die systematischen Bits X(t) repetiert, während die Padding-Einrichtung 1 lediglich vor den unteren Faltungscodierer 4, der die zweiten Paritätsbits Y'(t) erzeugt, geschaltet ist. Durch das Repetieren von einzelnen Bits der Bitsequenzen X(t) und Y(t) wird eine Anpassung der Anzahl der in den einzelnen Bitsequenzen X(t), Y(t), Y'(t) pro Datenblock ausgegebenen Bits erreicht. Bei diesem Ausführungsbeispiel wird für alle Datenblockgrößen N < M dieselbe Anzahl von Bits am Ausgang des Turbo-Codierers 2 erzielt (bei UMTS werden insgesamt $3 \cdot N + 12 = 3 \cdot 40 + 12 = 132$ Ausgangsbits erzeugt).

Das Problem der Anpassung der Datenblocklänge an die für den Turbo-Codierer 2 minimal erforderliche Datenblocklänge M kann alternativ zu dem zuvor beschriebenen Padding am Anfang der Datenblöcke auch dadurch realisiert werden, daß der jeweils zu codierende Datenblock mit Hilfe einer vor den Turbo-Codierer 2 geschalteten Repetierungseinrichtung durch Repetierung seiner Datenbits U(t) auf die minimale Blocklänge M des Turbo-Codierers 3 gebracht wird. der Turbo-Codierer 3 selbst kann bei diesem Ansatz unverändert bleiben. Die Repetierung kann sowohl zyklisch (d.h. Repetieren unterschiedlicher Bits nacheinander) als auch blockweise (d.h. mehrfaches Repetieren ein und desselben Bits) erfolgen.

Die vorliegende Erfindung wurde zuvor anhand der Verwendung in einem Sender, insbesondere einem UMTS-Mobilfunk-Sender, beschrieben. Selbstverständlich kann die Erfindung jedoch auch auf Empfänger ausgedehnt werden, wo ein erfindungsgemäß erzeugtes Sendesignal entsprechend dem jeweils zur Anpassung der Datenblocklänge verwendeten Schema verarbeitet werden muß.

## Patentansprüche

1. Verfahren zum Anpassen der einem Turbo-Codierer zuzuführenden Datenblöcke,
   wobei einem Datenblock, welcher dem Turbo-Codierer (2) zur Codierung der Datenbits des Datenblocks zuzuführen ist, zusätzliche Bits mit einem bekannten vordefinierten Wert hinzugefügt werden, so daß der daraus resultierende erweiterte Datenblock eine für die Codierung durch den Turbo-Codierer (2) minimal erforderliche Anzahl an Bits umfaßt,
   **dadurch gekennzeichnet,**
   **daß** die zusätzlichen Bits dem Datenblock vorangestellt werden.

2. Verfahren nach Anspruch 1,
   **dadurch gekennzeichnet,**
   **daß** die zusätzlichen Bits den vordefinierten Wert '0' besitzen.

3. Verfahren nach Anspruch 1 oder 2,
   **dadurch gekennzeichnet,**
   **daß** der von dem Turbo-Codierer (2) ausgegebene Bitstrom an einen Empfänger übertragen wird, wobei die vor der Turbo-Codierung dem Datenblock hinzugefügten zusätzlichen Bits aus dem von dem Turbo-Codierer (2) ausgegebenen codierten Bitstrom zumindest teilweise wieder entfernt werden, um nicht übertragen zu werden.

**4.** Verfahren nach Anspruch 3,
**dadurch gekennzeichnet,**
**daß** der Turbo-Codierer (2) abhängig von den Bits des ihm zur Turbo-Codierung zugeführten und um die zusätzlichen Bits erweiterten Datenblocks eine Bitsequenz (X) mit uncodierten systematischen Bits, eine Bitsequenz (Y) mit ersten codierten Paritätsbits und eine Bitsequenz (Y') mit zweiten codierten Paritätsbits erzeugt, und
**daß** die vor der Turbo-Codierung dem Datenblock hinzugefügten zusätzlichen Bits zumindest teilweise aus der Bitsequenz (X) mit den systematischen Bits und/oder der Bitsequenz (Y) mit den ersten Paritätsbits wieder entfernt werden.

**5.** Verfahren nach Anspruch 4,
**dadurch gekennzeichnet,**
**daß** die vor der Turbo-Codierung dem Datenblock hinzugefügten zusätzlichen Bits aus der von dem Turbo-Codierer (2) erzeugten jeweiligen Bitsequenz in Gruppen zu drei Bits entfernt werden.

**6.** Verfahren nach einem der Ansprüche 3-5,
**dadurch gekennzeichnet,**
**daß** die nicht zu übertragenden und dem Datenblock hinzugefügten zusätzlichen Bits markiert werden, wobei jedes markierte Bit bei der nachfolgenden Datenübertragung nicht übertragen wird.

**7.** Verfahren nach einem der vorhergehenden Ansprüche,
**dadurch gekennzeichnet,**
**daß** die vor der Turbo-Codierung dem Datenblock hinzugefügten zusätzlichen Bits in dem von dem Turbo-Codierer (2) ausgegebenen codierten Bitstrom zumindest teilweise durch Wiederholen von mindestens einem Datenbit des Datenblocks ersetzt werden.

**8.** Verfahren nach Anspruch 7,
**dadurch gekennzeichnet,**
**daß** der Turbo-Codierer (2) abhängig von den Bits des ihm zur Turbo-Codierung zugeführten und um die zusätzlichen Bits erweiterten Datenblocks eine Bitsequenz (X) mit uncodierten systematischen Bits, eine Bitsequenz (Y) mit ersten codierten Paritätsbits und eine Bitsequenz (Y') mit zweiten codierten Paritätsbits erzeugt, und
**daß** die vor der Turbo-Codierung dem Datenblock hinzugefügten zusätzlichen Bits wenigstens in der Bitsequenz (X) mit den systematischen Bits und/oder in der Bitsequenz (Y) mit den ersten Paritätsbits zumindest teilweise durch Wiederholen von mindestens einem systematischen Bit bzw. mindestens einem ersten Paritätsbit des Datenblocks ersetzt werden.

**9.** Verfahren nach Anspruch 8,

**dadurch gekennzeichnet,**
**daß** die Datenbits der jeweiligen Bitsequenz, in der die dem Datenblock hinzugefügten zusätzlichen Bits ersetzt werden sollen, nacheinander in einen Speicher geschrieben und zyklisch aus dem Speicher ausgelesen werden, um die gewünschten zusätzlichen Bits, welche dem Datenblock hinzugefügt worden sind, zu ersetzen.

**10.** Verfahren nach Anspruch 9,
**dadurch gekennzeichnet,**
**daß** der Wert derjenigen Bits Z(i) des Turbo-Codierers (2) in der jeweiligen Bitsequenz, welche ersetzt werden sollen, gemäß einer der folgenden Beziehungen bestimmt wird:

$$Z(i) = S(i \bmod (N+T)) \text{ für } 0 \leq i \leq M\text{-}1+T$$

oder

$$Z(i) = S((i+N\text{-}M) \bmod (N+T)) \text{ für } 0 \leq i \leq M\text{-}1+T,$$

wobei S(i) die in den Speicher geschriebenen Datenbits des jeweiligen Datenblocks, i die jeweilige Bitposition in dem Datenblock, N die ursprüngliche Länge des Datenblocks, M die für die Turbo-Codierung minimal erforderliche Anzahl an Bits pro Datenblock und T eine Anzahl von nach der Turbo-Codierung der jeweiligen Bitsequenz hinzugefügten Tail Bits bezeichnet.

**11.** Verfahren nach Anspruch 8,
**dadurch gekennzeichnet,**
**daß** die Datenbits der jeweiligen Bitsequenz, in welcher die dem Datenblock hinzugefügten zusätzlichen Bits ersetzt werden sollen, in einen Speicher geschrieben werden, wobei jeweils ein Datenbit aus dem Speicher ausgelesen und als Ersatz für mehrere zusätzliche Bits, welche dem entsprechenden Datenblock hinzugefügt worden sind, an entsprechenden Positionen in der jeweiligen Bitsequenz mehrfach wiederholt wird.

**12.** Verfahren nach Anspruch 11,
**dadurch gekennzeichnet,**
**daß** der Wert derjenigen Bits Z(i) des Turbo-Codierers (2) in der jeweiligen Bitsequenz, welche ersetzt werden sollen, gemäß folgender Beziehung bestimmt wird:

$$Z(i) = S\left(\frac{i \cdot (N+T)}{M+T}\right)$$

für $0 \leq i \leq M\text{-}1+T,$

wobei S(i) die in den Speicher geschriebenen Datenbits des jeweiligen Datenblocks, i die jeweilige Bitposition in dem Datenblock, N die ursprüngliche Länge des Datenblocks, M die für die Turbo-Codierung minimal erforderliche Anzahl an Bits pro Datenblock und T eine Anzahl von nach der Turbo-Codierung der jeweiligen Bitsequenz hinzugefügten Tail Bits bezeichnet.

13. Verfahren nach Anspruch 11,
**dadurch gekennzeichnet,**
**daß** eine erste Gruppe von in dem Speicher gespeicherten Datenbits als Ersatz für die entsprechenden zusätzlichen Bits

$$\left(\frac{M+T}{N+T}\right)\text{-mal}$$

wiederholt werden, während eine zweite Gruppe von in dem Speicher gespeicherten Datenbits

$$\left[\left(\frac{M+T}{N+T}\right)-1\right]\text{-mal}$$

wiederholt werden,
wobei N die ursprüngliche Länge des Datenblocks, M die für die Turbo-Codierung minimal erforderliche Anzahl an Bits pro Datenblock und T eine Anzahl von nach der Turbo-Codierung der jeweiligen Bitsequenz hinzugefügten Tail Bits bezeichnet.

14. Verfahren nach Anspruch 1 oder 2,
**dadurch gekennzeichnet,**
**daß** der Turbo-Codierer (2) mit einem ersten Faltungscodierer (3) eine Bitsequenz (X) mit uncodierten systematischen Bits und eine Bitsequenz (Y) mit ersten codierten Paritätsbits sowie mit einem zweiten Faltungscodierer (4) eine Bitsequenz (Y') mit zweiten codierten Paritätsbits erzeugt, wobei dem ersten Faltungscodierer (3) die Datenbits des ursprünglichen Datenblocks und dem zweiten Faltungscodierer (4) die Datenbits mit den vorangestellten zusätzlichen Bits zugeführt werden, und wobei mindestens ein Bit der Bitsequenz (X) mit den systematischen Bits und mindestens ein Bit der Bitsequenz (Y) mit den ersten Paritätsbits in der entsprechenden Bitsequenz wiederholt wird, um die Bitanzahl der für das zu codierende Datenwort in der entsprechenden Bitsequenz (X, Y) ausgegebenen Bits an die Bitanzahl der Bitsequenz (Y') mit den zweiten Paritätsbits anzupassen.

15. Kommunikationsvorrichtung,
mit einem Turbo-Codierer (2), und
mit einer Datenblock-Anpassungseinrichtung (1), um einem Datenblock, welcher dem Turbo-Codierer (2) zur Codierung der Datenbits des Datenblocks zuzuführen ist, zusätzliche Bits mit einem bekannten Wert hinzuzufügen, so daß der von der Datenblock-Anpassungseinrichtung (1) ausgegebene und um die zusätzlichen Bits erweiterte Datenblock eine für die Codierung durch den Turbo-Codierer (2) minimal erforderliche Anzahl an Bits umfaßt,
**dadurch gekennzeichnet,**
**daß** die Datenblock-Anpassungseinrichtung (1) derart ausgestaltet ist, daß sie die zusätzlichen Bits dem Datenblock voranstellt.

16. Kommunikationsvorrichtung nach Anspruch 15,
**dadurch gekennzeichnet,**
**daß** die Kommunikationsvorrichtung zur Durchführung des Verfahrens nach einem der Ansprüche 1-14 ausgestaltet ist.

17. Kommunikationsvorrichtung nach einem der Ansprüche 15-16,
**dadurch gekennzeichnet,**
**daß** die Kommunikationsvorrichtung (1) eine Sendevorrichtung, insbesondere eine (UMTS-)Mobilfunksendevorrichtung, ist.

18. Kommunikationsvorrichtung,
**dadurch gekennzeichnet,**
**daß** die Kommunikationsvorrichtung zum Empfangen und Auswerten eines von einer anderen Kommunikationsvorrichtung gemäß dem Verfahren nach einem der Ansprüche 1-14 verarbeiteten und anschließend an die Kommunikationsvorrichtung gesendeten Bitstroms ausgestaltet ist.

19. Kommunikationsvorrichtung nach Anspruch 18, wobei der Turbo-Codierer (2) der sendenden Kommunikationsvorrichtung abhängig von den Bits des ihm jeweils zur Turbo-Codierung zugeführten und um die zusätzlichen Bits erweiterten Datenblocks eine Bitsequenz (X) mit uncodierten systematischen Bits, eine Bitsequenz (Y) mit ersten codierten Paritätsbits und eine Bitsequenz (Y') mit zweiten codierten Paritätsbits erzeugt,
**dadurch gekennzeichnet,**
**daß** die zum Empfangen ausgestaltete Kommunikationsvorrichtung die von der sendenden Kommunikationsvorrichtung eingefügten Bits zumindest in der Bitsequenz (X) mit den uncodierten systematischen Bits und/oder in der Bitsequenz (Y) mit den ersten codierten Paritätsbits nicht auswertet.

**Claims**

1. Method for adapting the data blocks to be supplied to a turbo coder,
   additional bits with a known predefined value being added to a data block which is to be supplied to the turbo coder (2) for coding the data bits of the data block, so that the extended data block resulting therefrom comprises a minimum required number of bits for the coding by the turbo coder (2), **characterized**
   **in that** the additional bits are placed in a manner preceding the data block.

2. Method according to Claim 1,
   **characterized**
   **in that** the additional bits have the predefined value "0".

3. Method according to Claim 1 or 2,
   **characterized**
   **in that** the bit stream output by the turbo coder (2) is transmitted to a receiver, the additional bits added to the data block before the turbo coding being at least partly removed again from the coded bit stream output by the turbo coder (2), in order not to be transmitted.

4. Method according to Claim 3,
   **characterized**
   **in that** the turbo coder (2), depending on the bits of the data block which is supplied to it for turbo coding and is extended by the additional bits, generates a bit sequence (X) with uncoded systematic bits, a bit sequence (Y) with first coded parity bits and a bit sequence (Y') with second coded parity bits, and
   **in that** the additional bits added to the data block before the turbo coding are at least partly removed again from the bit sequence (X) with the systematic bits and/or the bit sequence (Y) with the first parity bits.

5. Method according to Claim 4,
   **characterized**
   **in that** the additional bits added to the data block before the turbo coding are removed from the respective bit sequence generated by the turbo coder (2) in groups of three bits.

6. Method according to one of Claims 3-5,
   **characterized**
   **in that** the additional bits which are added to the data block and are not to be transmitted are marked, each marked bit not being transmitted during the subsequent data transmission.

7. Method according to one of the preceding Claims,
   **characterized**

   **in that** the additional bits added to the data block before the turbo coding are at least partly replaced, in the coded bit stream output by the turbo coder (2), by repetition of at least one data bit of the data block.

8. Method according to Claim 7,
   **characterized in that** the turbo coder (2), depending on the bits of the data block which is supplied to it for turbo coding and is extended by the additional bits, generates a bit sequence (X) with uncoded systematic bits, a bit sequence (Y) with first coded parity bits and a bit sequence (Y') with second coded parity bits, and
   **in that** the additional bits added to the data block before the turbo coding are at least partly replaced, at least in the bit sequence (X) with the systematic bits and/or in the bit sequence (Y) with the first parity bits, by repetition of at least one systematic bit and/or at least one first parity bit of the data block.

9. Method according to Claim 8,
   **characterized**
   **in that** the data bits of the respective bit sequence in which the additional bits added to the data block are intended to be replaced are successively written to a memory and cyclically read out from the memory in order to replace the desired additional bits which have been added to the data block.

10. Method according to Claim 9,
    **characterized**
    **in that** the value of those bits Z(i) of the turbo coder (2) in the respective bit sequence which are intended to be replaced is determined in accordance with one of the following relationships:

    $$Z(i) = S(I \bmod (N+T) \text{ for } 0 \leq i \leq M - 1 + T$$

    or

    $$Z(i) = S((I+N-M) \bmod (N+T)) \text{ for } 0 \leq i \leq M - 1 + T,$$

    where S(i) designates the data bits of the respective data block that are written to the memory, i designates the respective bit position in the data block, N designates the original length of the data block, M designates the minimum required number of bits per data block for the turbo coding, and T designates a number of tail bits added to the respective bit sequence after the turbo coding.

11. Method according to Claim 8,
    **characterized**
    **in that** the data bits of the respective bit sequence in which the additional bits added to the data block are intended to be replaced are written to a memory, in each case one data bit being read out from the memory and being multiply repeated as replacement for a plurality of additional bits, which have been added to the corresponding data block, at corresponding positions in the respective bit sequence.

12. Method according to Claim 11, **characterized** **in that** the value of those bits Z(i) of the turbo coder (2) in the respective bit sequence which are intended to be replaced is determined in accordance with the following relationship:

$$Z(i) \;=\; S\left(\frac{i \,\cdot\, (N \,+\, T)}{M \,+\, T}\right)$$

for $0 \leq i \leq M - 1 + T$
where S(i) designates the data bits of the respective data block that are written to the memory, i designates the respective bit position in the data block, N designates the original length of the data block, M designates the minimum required number of bits per data block for the turbo coding, and T designates a number of tail bits added to the respective bit sequence after the turbo coding.

13. Method according to Claim 11, **characterized** **in that** a first group of data bits stored in the memory are repeated

$$\left(\frac{M + T}{N + T}\right)$$

times as replacement for the corresponding additional bits, while a second group of data bits stored in the memory are repeated

$$\left[\left(\frac{M + T}{N + T}\right) - 1\right]$$

times,
where N designates the original length of the data block, M designates the minimum required number of bits per data block for the turbo coding, and T designates a number of tail bits added to the respective bit sequence after the turbo coding.

14. Method according to Claim 1 or 2, **characterized**

**in that** the turbo coder (2) generates a bit sequence (X) with uncoded systematic bits and a bit sequence (Y) with first coded parity bits by means of a first convolution coder (3) and also a bit sequence (Y') with second coded parity bits by means of a second convolution coder (4), the data bits of the original data block being supplied to the first convolution coder (3) and the data bits with the additional bits placed in a preceding manner being supplied to the second convolution coder (4), and
at least one bit of the bit sequence (X) with the systematic bits and at least one bit of the bit sequence (Y) with the first parity bits being repeated in the corresponding bit sequence in order to adapt the number of bits output for the data word to be coded in the corresponding bit sequence (X, Y) to the number of bits of the bit sequence (Y') with the second parity bits.

15. Communications apparatus,
having a turbo coder (2), and
having a data block adapting device (1) in order to add additional bits with a known value to a data block which is to be supplied to the turbo coder (2) for coding the data bits of the data block, so that the data block which is extended by the additional bits and is output by the data block adapting device (1) comprises a minimum required number of bits for the coding by the turbo coder (2),
**characterized**
**in that** the data block adapting device (1) is configured in such a way that it places the additional bits in a manner preceding the data block.

16. The communications apparatus according to Claim 15,
**characterized**
**in that** the communications apparatus is configured for carrying out method according to one of Claims 1-14.

17. Communications apparatus according to one of Claims 15-16,
**characterized**
**in that** the communications apparatus (1) is a transmission apparatus, in particular a (UMTS) mobile. radio transmission apparatus.

18. Communications apparatus,
**characterized**
**in that** the communications apparatus is configured for receiving and evaluating a bit stream that is processed by another communications apparatus in accordance with method according to one of Claims 1-14 and is subsequently transmitted to the communications apparatus.

19. The communications apparatus according to Claim 18,
the turbo coder (2) of the transmitting communications apparatus, depending on the bits of the data block which is supplied to it for turbo coding in each case and is extended by the additional bits, generating a bit sequence (X) with uncoded systematic bits, a bit sequence (Y) with first coded parity bits and a bit sequence (Y') with second coded parity bits,
**characterized in that** the communications apparatus configured for reception does not evaluate the bits inserted by the transmitting communications apparatus at least in the bit sequence (X) with the uncoded systematic bits and/or in the bit sequence (Y) with the first coded parity bits.

## Revendications

1. Procédé pour adapter les blocs de données à amener à un turbo-codeur, des bits additionnels avec une valeur prédéfinie connue étant ajoutés à un bloc de données devant être amené au turbo-codeur (2) pour le codage des bits de données du bloc de données, de sorte que le bloc de données élargi qui en résulte comprend un nombre de bits minimal requis pour le codage par le turbo-codeur (2),
**caractérisé en ce que**
les bits additionnels sont antéposés au bloc de données.

2. Procédé selon la revendication 1,
**caractérisé en ce que**
les bits additionnels ont la valeur prédéfinie «0».

3. Procédé selon la revendication 1 ou 2,
**caractérisé en ce que**
le train de bits délivré par le turbo-codeur (2) est transmis à un récepteur, les bits additionnels ajoutés au bloc de données avant le turbo-codage étant, au moins partiellement, de nouveau retirés du train de bits codé délivré par le turbo-codeur (2) pour ne pas être transmis.

4. Procédé selon la revendication 3,
**caractérisé en ce que**
le turbo-codeur (2), en dépendance des bits du bloc de données qui lui a été amené pour turbo-codage et qui a été élargi par les bits additionnels, génère une séquence de bits (X) avec des bits systématiques non codés, une séquence de bits (Y) avec des premiers bits de parité codés et une séquence de bits (Y') avec des deuxièmes bits de parité codés et **en ce que** les bits additionnels ajoutés au bloc de données avant le turbo-codage sont, au moins partiellement, de nouveau retirés de la séquence de bits (X) avec les bits systématiques et/ou de la séquence de bits (Y) avec les premiers bits de parité.

5. Procédé selon la revendication 4,
**caractérisé en ce que**
les bits additionnels ajoutés au bloc de données avant le turbo-codage sont retirés par groupes de trois bits de la séquence de bits respective générée par le turbo-codeur (2).

6. Procédé selon l'une des revendications 3 à 5,
**caractérisé en ce que**
les bits additionnels qui ne sont pas à transmettre et sont ajoutés au bloc de données sont marqués, chaque bit marqué n'étant pas transmis lors de la transmission de données suivante.

7. Procédé selon l'une des revendications précédentes,
**caractérisé en ce que**
les bits additionnels ajoutés au bloc de données avant le turbo-codage sont, au moins partiellement, remplacés, dans le train de bits codé délivré par le turbo-codeur (2), par la répétition d'un moins un bit de données du bloc de données.

8. Procédé selon la revendication 7,
**caractérisé en ce que**
le turbo-codeur (2), en dépendance des bits du bloc de données qui lui a été amené pour turbo-codage et qui a été élargi par les bits additionnels, génère une séquence de bits (X) avec des bits systématiques non codés, une séquence de bits (Y) avec des premiers bits de parité codés et une séquence de bits (Y') avec des deuxièmes bits de parité codés et **en ce que** les bits additionnels ajoutés au bloc de données avant le turbo-codage sont, au moins partiellement, remplacés au moins dans la séquence de bits (X) avec les bits systématiques et/ou dans la séquence de bits (Y) avec les premiers bits de parité par répétition d'au moins un bit systématique resp. d'au moins un premier bit de parité du bloc de données.

9. Procédé selon la revendication 8,
**caractérisé en ce que**
les bits de données de la séquence de bits respective dans laquelle il s'agit de remplacer les bits additionnels ajoutés au bloc de données sont enregistrés successivement dans une mémoire et extraits cycliquement de la mémoire pour remplacer les bits additionnels voulus qui ont été ajoutés au bloc de données.

10. Procédé selon la revendication 9,
**caractérisé en ce que**
la valeur des bits $Z(i)$ du turbo-codeur (2) dans la séquence de bits respective, lesquels sont à remplacer, est déterminée selon l'une des relations suivantes:

$$Z(i) = S(i \bmod (N+T)) \text{ pour } 0 \le i \le M - 1 + T$$

ou

$$Z(i) = S((i+N-M) \bmod (N+T)) \text{ pour } 0 \le i \le M - 1 + T,$$

S(i) désignant les bits de données du bloc de données respectif enregistrés dans la mémoire, i désignant la position de bit respective dans le bloc de données, N désignant la longueur d'origine du bloc de données, M désignant le nombre de bits par bloc de données minimal requis pour le turbo-codage et T désignant un nombre de bits de queue (Tail Bits) ajoutés à la séquence de bits respective après le turbo-codage.

11. Procédé selon la revendication 8,
**caractérisé en ce que**
les bits de données de la séquence de bits respective dans laquelle il s'agit de remplacer les bits additionnels ajoutés au bloc de données sont enregistrés dans une mémoire, un bit de données étant respectivement extrait de la mémoire et répété plusieurs fois, à des positions correspondantes dans la séquence de bits respective, en remplacement de plusieurs bits additionnels qui ont été ajoutés au bloc de données correspondant.

12. Procédé selon la revendication 11,
**caractérisé en ce que**
la valeur des bits Z(i) du turbo-codeur (2) dans la séquence de bits respective, lesquels sont à remplacer, sont déterminés selon la relation suivante:

$$Z(i) = S\left( \frac{i \cdot (N+T)}{M+T} \right)$$

pour $0 \le i \le M-1+T$,
S(i) désignant les bits de données du bloc de données respectif enregistrés dans la mémoire, i désignant la position de bit respective dans le bloc de données, N désignant la longueur d'origine du bloc de données, M désignant le nombre de bits par bloc de données minimal requis pour le turbo-codage et T désignant un nombre de bits de queue (Tail Bits) ajoutés à la séquence de bits respective après le turbo-codage.

13. Procédé selon la revendication 11, **caractérisé en ce qu'**un premier groupe de bits de données enregistrés dans la mémoire est répété

$$\left( \frac{M+T}{N+T} \right)$$

fois en remplacement des bits additionnels correspondants, tandis qu'un deuxième groupe de bits de données enregistré dans la mémoire est répété

$$\left[ \left( \frac{M+T}{N+T} \right) - 1 \right]$$

fois,
N désignant la longueur d'origine du bloc de données, M désignant le nombre de bits par bloc de données minimal requis pour le turbo-codage et T désignant un nombre de bits de queue (Tail Bits) ajoutés à la séquence de bits respective après le turbo-codage.

14. Procédé selon la revendication 1 ou 2,
**caractérisé en ce que**
le turbo-codeur (2) génère, avec un premier codeur convolutif (3), une séquence de bits (X) avec des bits systématiques non codés et une séquence de bits (Y) avec des premiers bits de parité codés et, avec un deuxième codeur convolutif (4), une séquence de bits (Y') avec des deuxièmes bits de parité codés, les bits de données du bloc de données d'origine étant amenés au premier codeur convolutif (3) et les bits de données avec les bits additionnels antéposés étant amenés au deuxième codeur convolutif (4) et au moins un bit de la séquence de bits (X), avec les bits systématiques, et
au moins un bit de la séquence de bits (Y), avec les premiers bits de parité, étant répétés dans la séquence de bits correspondante, pour adapter le nombre des bits délivrés pour le mot de données à coder dans la séquence de bits correspondante (X, Y) au nombre de bits de la séquence de bits (Y') avec les deuxièmes bits de parité.

15. Dispositif de communication
comprenant un turbo-codeur (2) et
un dispositif d'adaptation de bloc de données (1) pour ajouter des bits additionnels avec une valeur connue à un bloc de données à amener au turbo-codeur (2) pour le codage des bits de données du bloc de données de sorte que le bloc de données délivré par le dispositif d'adaptation de bloc de données (1) et élargi par les bits additionnels comprend un nombre de bits minimal requis pour le codage par le turbo-codeur (2),
**caractérisé en ce que**
le dispositif d'adaptation de bloc de données (1) est configuré de manière telle qu'il antépose les bits additionnels au bloc de données.

**16.** Dispositif de communication selon la revendication 15,

**caractérisé en ce que**

le dispositif de communication est configuré pour exécuter le procédé selon l'une des revendication 1 à 14.

**17.** Dispositif de communication selon l'une des revendications 15 - 16,

**caractérisé en ce que**

le dispositif de communication (1) est un dispositif émetteur, et plus particulièrement un dispositif émetteur radio mobile (UMTS).

**18.** Dispositif de communication,

**caractérisé en ce que**

le dispositif de communication est configuré pour la réception et l'évaluation d'un train de bits traité par un autre dispositif de communication selon le procédé selon l'une des revendications 1 à 14 et ensuite envoyé au dispositif de communication.

**19.** Dispositif de communication selon la revendication 18,

**caractérisé en ce que**

le turbo-codeur (2) du dispositif de communication émetteur, en dépendance des bits du bloc de données qui lui a été respectivement amené pour turbo-codage et qui a été élargi par les bits additionnels, génère une séquence de bits (X) avec des bits systématiques non codés, une séquence de bits (Y) avec des premiers bits de parité codés et une séquence de bits (Y') avec des deuxièmes bits de parité codés, **caractérisé en ce que** le dispositif de communication configuré pour la réception n'analyse pas les bits insérés par le dispositif de communication émetteur au moins dans la séquence de bits (X) avec les bits systématiques non codés et/ou dans la séquence de bits (Y) avec les premiers bits de parité codés.

FIG 1

FIG 2

FIG 3 (Stand der Technik)